# EUROPÄISCHE PATENTANMELDUNG

(11) **EP 0 768 754 A2**
(43) Veröffentlichungstag der Anmeldung: **16.04.1997**
(21) Anmeldenummer: 96112477.3
(22) Anmeldetag: 02.08.1996
(51) Int. Cl.: H03G 3/30

(54) **Verfahren zur Unterdrückung von Störsignalen bei geregelten Verstärkern und geregelter Verstärker**

(30) Priorität: 14.10.1995 DE 19538305
(71) Anmelder: ROBERT BOSCH GMBH, 70442 Stuttgart (DE)
(72) Erfinder: Bitar, Omar, 12277 Berlin (DE)

(57) **Zusammenfassung**

Es wird ein Verfahren für geregelte Verstärker (1) vorgeschlagen, das der konstanten Unterdrückung von Störsignalen in der Pause zwischen zwei Nutzimpulsen dient. Der geregelte Verstärker (1) umfaßt ein Verstärkerelement (13) und Mittel zur Regelung (3) der Verstärkung und/oder der Eingangsgröße des geregelten Verstärkers (1) in Abhängigkeit der Größe des Ausgangssignals des Verstärkerelements (13). Das Verfahren sieht vor, die Steuergröße der Mittel zur Regelung (3) bei Absinken der Eingangsgröße des geregelten Verstärkers (1) für eine vorgegebene Zeitdauer auf dem zuletzt eingestellten Wert zu halten. Auf diese Weise bleibt eine bei der Nutzimpulsverstärkung vorherrschende Störsignalunterdrückung nach Absinken des Nutzsignals für die vorgegebene Zeitdauer bestehen.

Es wird außerdem ein geregelter Verstärker (1) vorgeschlagen, der in der Pause zwischen zwei Nutzimpulsen eine konstante Unterdrückung von Störsignalen aufweist. Der geregelte Verstärker (1) ist prinzipiell wie oben beschrieben aufgebaut. Das Ausgangssignal des Verstärkerelements (13) ist über einen Spitzenwertgleichrichter (7, 4) den Mitteln zur Regelung (3) zugeführt. Zwischen dem Spitzenwertgleichrichter (7, 4) und den Mitteln zur Regelung (3) ist ein Halteglied (5, 8, 10) angeordnet, das die Steuergröße der Mittel zur Regelung (3) bei Absinken der Eingangsgröße des geregelten Verstärkers (1) für eine vorgegebene Zeitdauer auf dem zuletzt vorhandenen Wert hält.

## Beschreibung

### Stand der Technik

Die Erfindung geht von einer Verstärkungsregelung nach der Gattung der unabhängigen Ansprüche aus. Aus der DE 29 40 078 A1 ist ein geregelter Verstärker bekannt, bei dem die Verstärkung in Abhängigkeit von der Ausgangsspannung; des Verstärkers geregelt ist. Ein der Ausgangsspannung des Verstärkers proportionales Signal ist dabei einem Spitzenwertgleichrichter zugeführt, der einen Lichtsender über ein aktives Element ansteuert. Mit dem Lichtsender sind Fotowiderstände in einem Gegenkopplungszweig des Verstärkers optisch gekoppelt.

### Vorteile der Erfindung

Das erfindungsgemäße Verfahren mit den Merkmalen des Anspruchs 1 bzw. der geregelte Verstärker nach Anspruch 2 hat demgegenüber den Vorteil, daß eine bei der Nutzsignalverstärkung vorherrschende Störsignalunterdrückung nach Absinken des Nutzsignals für eine vorgegebene Zeitdauer bestehen bleibt.

Durch die in den Unteransprüchen aufgeführten Maßnahmen sind vorteilhafte Weiterbildungen und Verbesserungen des in Anspruch 2 angegebenen geregelten Verstärkers möglich.

Gemäß Anspruch 3 bzw. 5 wird der Vorteil erreicht, daß die Realisierung des Haltegliedes als RC-Glied mit Diodenvorschaltung wenig Aufwand erfordert und eine kurze Zeitdauer für das Ausschwingen des Verstärkers aus dem geregelten in den ungeregelten Zustand ermöglicht.

Als weiterer Vorteil ist anzusehen, daß gemäß Anspruch 7 durch die Verwendung eines zweiten Verstärkerelements der Regeleinsatz des geregelten Verstärkers in Abhängigkeit der Differenz der Arbeitspunkte der beiden Verstärkerelemente vorgegeben werden kann.

Durch die gemäß Anspruch 8 vorschaltbaren Widerstände lassen sich der Klirrfaktor und der Einfluß eines kurzzeitigen Störsignals hoher Amplitude auf den Regeleinsatz verringern.

Vorteilhaft gemäß Anspruch 9 ist die Maßnahme, daß die Arbeitspunkte der beiden Verstärkerelemente über einen Spannungsteiler eingestellt sind. Dadurch wird erreicht, daß die Spannungsdifferenz zwischen den beiden Arbeitspunkten und damit der Regeleinsatz hochpräzise ist.

### Zeichnung

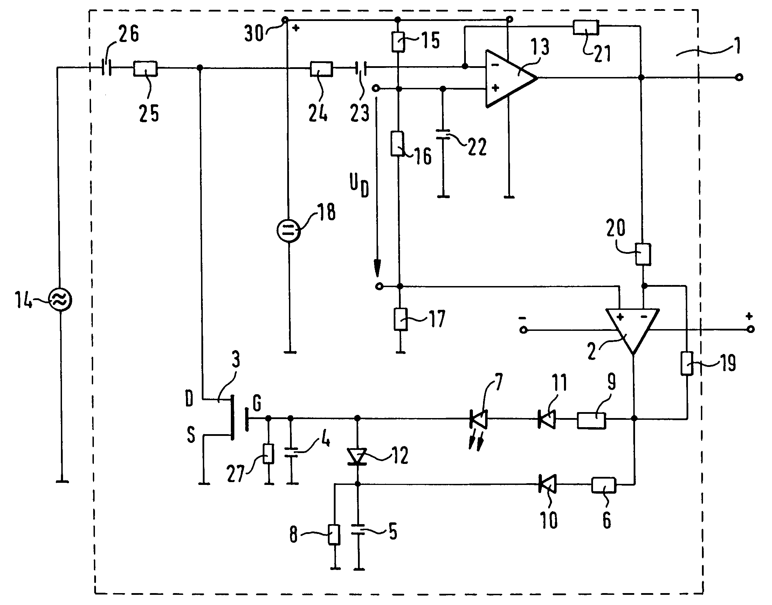

Ein Ausführungsbeispiel der Erfindung ist in der Zeichnung dargestellt und in der nachfolgenden Beschreibung näher erläutert. Die Figur zeigt einen geregelten Verstärker.

### Beschreibung des Ausführungsbeispiels

In der Figur bezeichnet 1 einen geregelten Verstärker, der von einer Signalquelle 14 über einen Kondensator 26 gespeist ist. Über einen ersten Spannungsteiler aus einem Widerstand 25 und einem n-Kanal-Feldeffekttransistor 3, dessen Drain-Anschluß mit dem Widerstand 25 und dessen Source-Anschluß mit der Masseleitung als Bezugspotential verbunden ist, wird ein dem gleichspannungsfreien Eingangssignal der Signalquelle 14 proportionales Signal über eine an den Drain-Anschluß des Feldeffekttransistors 3 angeschlossene Serienschaltung eines Widerstandes 24 mit einem Kondensator 23 dem invertierenden Eingang eines ersten Operationsverstärkers 13 zugeführt. Eine Gleichspannungsquelle 18 ist an ihrem Pluspol 30 über eine Widerstand 15 an den nicht invertierenden Eingang des ersten Operationsverstärkers 13 angeschlossen, der über einen Kondensator 22 mit dem Bezugspotential verbunden ist. Über einen zweiten Spannungsteiler aus den Widerständen 16 und 17 wird eine der Gleichspannung am nicht invertierenden Eingang des ersten Operationsverstärkers 13 proportionale Gleichspannung dem nicht invertierenden Eingang eines zweiten Operationsverstärkers 2 zugeführt, dessen invertierender Eingang über einen Widerstand 20 mit dem Ausgang des ersten Operationsverstärkers 13 verbunden ist. Der Ausgang des ersten Operationsverstärkers 13 ist mit seinem invertierenden Eingang über einen Widerstand 21 verbunden. Der Ausgang des zweiten Operationsverstärkers 2 ist mit seinem invertierenden Eingang über einen Widerstand 19 verbunden. Die Anode einer Leuchtdiode 7 ist mit der Kathode einer vierten Diode 11 verbunden, deren Anode über einen Widerstand 9 an den Ausgang des zweiten Operationsverstärkers 2 angeschlossen ist. Die Kathode der Leuchtdiode 7 ist mit der Anode einer zweiten Diode 12 verbunden. Die Anode der zweiten Diode 12 ist an den Gate-Anschluß des Feldeffekttransistors 3 angeschlossen und über einen ersten Kondensator 4 mit dem Bezugspotential verbunden. Dem Kondensator 4 ist ein Widerstand 27 parallelgeschaltet. Die Kathode der zweiten Diode 12 ist über einen zweiten Kondensator 5 mit dem Bezugspotential und mit der Kathode einer dritten Diode 10 verbunden. Die Anode der dritten Diode 10 ist über einen Widerstand 6 mit dem Ausgang des zweiten Operationsverstärkers 2 verbunden. Dem zweiten Kondensator 5 ist ein Widerstand 8 parallel geschaltet. Im Schaltbild ist bei dem ersten Operationsverstärker 13 und bei dem zweiten Operationsverstärker 2 noch die Zuführung von Betriebsspannungen angedeutet.

Der Arbeitspunkt des ersten Operationsverstärkers 13 liegt, bedingt durch den Spannungsteiler 15, 16, 17 um eine Spannungsdifferenz U_{D} höher als der Arbeitspunkt des zweiten Operationsverstärkers 2. Die Spannungsdifferenz U_{D} hängt von den Widerständen 15, 16 und 17 und von der Gleichspannung der Gleichspannungsquelle 18 ab und legt den Regeleinsatz des geregelten Verstärkers 1 fest. Solange die Ausgangsspannung des ersten Operationsverstärkers 13 betragsmäßig größer als der Arbeitspunkt des zweiten Operationsverstärkers 2 ist, gibt der zweite Operationsverstärker 2 ein von der Ausgangsspannung des ersten Operationsverstärkers 13 unabhängiges Signal ab. Dies ist bei einem Ausgangssignal des ersten Operationsverstärkers 13 mit Amplituden, die kleiner als U_{D} sind, der Fall. In diesem Zustand arbeitet der geregelte Verstärker 1 nicht im Regelbetrieb. Überschreiten die Amplituden die Spannungsdifferenz U_{D}, dann werden die Teilhalbwellen, die den Spannungswert, der sich nach Abzug der Spannungsdifferenz U_{D} vom Arbeitspunkt des ersten Operationsverstärkers 13 ergibt, unterschreiten, vom zweiten Operationsverstärker 2 invertiert und verstärkt, so daß am Ausgang des zweiten Operationsverstärkers 2 ein positives Signal anliegt. Die Spannung am Kondensator 4 des Spitzenwertgleichrichters 7, 4 ist dann abhängig von der Amplitude des Ausgangssignals des ersten Operationsverstärkers 13 und steuert den Innenwiderstand des Feldeffekttransistors 3. Der geregelte Verstärker 1 arbeitet dann im Regelbetrieb. Mit zunehmender Ansteuerspannung wird der Innenwiderstand des n-Kanal-Feldeffekttransistors 3 kleiner und damit auch der Anteil der Eingangsspannung des geregelten Verstärkers 1, der dem ersten Operationsverstärker 13 zugeführt ist. Auf diese Weise wird die Amplitude der Ausgangsspannung auf einen konstanten Wert geregelt. Die zum Einschwingen in den Regelbetrieb benötigte Zeit hängt von den Widerständen 6 und 9 sowie dem ersten und dem zweiten Kondensator 4 und 5 ab.

Eine Spitzenwertgleichrichtung findet auch durch die dritte Diode 10 und den zweiten Kondensator 5 statt. Dabei besitzt im Regelbetrieb die Anode der zweiten Diode 12 aufgrund eines erhöhten Spannungsabfalls an der Leuchtdiode 7 und der vierten Diode 11 gegenüber dem Spannungsabfall an der dritten Diode 10 ein geringeres Potential als die Kathode der zweiten Diode 12, so daß die zweite Diode 12 sperrt. Bei Absinken des Eingangssignals des geregelten Verstärkers 1 kann sich der erste Kondensator 4 zunächst während einer Haltezeit nicht entladen, da der Feldeffekttransistor 3 einen hohen Eingangswiderstand hat, die Leuchtdiode 7 und die vierte Diode 11 sperren und die zweite Diode 12 einen Spannungsabfall in Sperrichtung aufweist. Über den Widerstand 8 entlädt sich daher zunächst nur der zweite Kondensator 5. Dadurch sinkt das Potential an der Kathode der zweiten Diode 12. Sobald dieses Potential das Potential an der Anode der zweiten Diode 12 ausreichend unterschreitet, beginnt der erste Kondensator 4, sich über den Widerstand 8 zu entladen. Auf diese Weise wird die Störimpulsunterdrückung während der Haltezeit aufrechterhalten.

Der Widerstand 9 bildet mit dem ersten Kondensator 4 einen ersten Tiefpaß, dessen Glättungswirkung den Klirrfaktor des Verstärkers reduziert. Der Widerstand 6 bildet mit dem zweiten Kondensator 5 einen zweiten Tiefpaß, der zusammen mit dem ersten Tiefpaß den Einfluß kurzzeitiger Störimpulse großer Amplitude auf den Regeleinsatz reduziert. Nach Ablauf der Haltezeit erfolgt eine schnelle Entladung des ersten Kondensators 4 über den Widerstand 8. Dadurch ist das Ausschwingen vom geregelten in den ungeregelten Zustand in kurzer Zeit möglich.

Der Widerstand 27 hat die Aufgabe, den ersten Kondensator 4 im geregelten Zustand so zu entladen, daß eine Entladung des zweiten Kondensators 5 über den Widerstand 8 zu keiner wesentlichen Änderung des Spannungsabfalls an der zweiten Diode 12 und damit der Haltezeit führt. Der Widerstand 27 muß jedoch sehr hochohmig dimensioniert sein, damit bei Absinken der Eingangsgröße des geregelten Verstärkers 1 während der Haltezeit keine nennenswerte Entladung des ersten Kondensators 4 über den Widerstand 27 erfolgt.

In einer weiteren Ausführungsform sind die Anoden der dritten und der vierten Diode 10 und 11 miteinander und über einen einzigen Widerstand, der statt der beiden Widerstände 6 und 9 verwendet wird und deren Funktion übernimmt, mit dem Ausgang des zweiten Operationsverstärkers 2 verbunden.

Weiterhin ist für die vierte Diode 11 die Verwendung einer Leuchtdiode möglich, der auch noch weitere Leuchtdioden gleicher Polaritätsrichtung vorgeschaltet werden können. Auf diese Weise ist eine Erhöhung des Spannungsabfalls an der zweiten Diode 12 in Sperrichtung möglich. Bei entsprechender Verringerung des Widerstandes 8 bleibt die Haltezeit unverändert, wohingegen die Dauer für das Ausschwingen vom geregelten in den ungeregelten Zustand verkürzt wird.

Eine weitere Ausführungsform sieht statt der Leuchtdiode 7 die Verwendung einer Zener-Diode mit im Vergleich zur vierten Diode 11 entgegengesetzter Polaritätsrichtung vor. Dabei kommt es im Regelbetrieb ebenfalls zur gewünschten Sperrung der zweiten Diode 12. Die vierte Diode 11 hat dann primär die Aufgabe, den Strom durch die Zener-Diode während der Haltezeit zu begrenzen.

## Patentansprüche

1. Verfahren zur Unterdrückung von Störsignalen bei einem geregelten Verstärker (1) mit Mitteln zur Regelung (3), die die Verstärkung und/oder die Eingangsgröße des geregelten Verstärkers (1) in Abhängigkeit der Größe des Ausgangssignals des geregelten Verstärkers (1) regeln, dadurch gekennzeichnet, daß die Steuergröße für die Mittel zur Regelung (3) bei Absinken der Eingangsgröße für eine vorgegebene Zeit auf dem zuletzt vorhandenen Wert gehalten wird.

2. Geregelter Verstärker (1) mit einem ersten Verstärkerelement (13), dessen Ausgangssignal einem Spitzenwertgleichrichter (7, 4) zugeführt ist, wobei das Ausgangssignal des Spitzenwertgleichrichters (7, 4) Mittel zur Regelung (3) der Verstärkung und/oder der Eingangsgröße des geregelten Verstärkers (1) zugeführt ist, dadurch gekennzeichnet, daß zwischen dem Spitzenwertgleichrichter (7, 4) und den Mitteln zur Regelung (3) ein Halteglied (5, 8, 10) angeordnet ist und daß das Halteglied (5, 8, 10) das Ausgangssignal des Spitzenwertgleichrichters (7, 4) bei Absinken der Eingangsgröße des geregelten Verstärkers (1) für eine vorgegebene Zeit auf dem zuletzt vorhandenen Wert hält.

3. Geregelter Verstärker nach Anspruch 2, dadurch gekennzeichnet, daß als Spitzenwertgleichrichter (7, 4) eine Leuchtdiode (7) Verwendung findet, der ein erster Kondensator (4) nachgeschaltet ist, daß nach der Leuchtdiode (7) eine zweite Diode (12) in Durchlaßrichtung geschaltet ist und am anderen Anschluß der zweiten Diode (12) ein RC-Glied (5, 8) angeordnet ist, daß dieser Anschluß der zweiten Diode (12) außerdem über eine dritte Diode (10) auf den Eingang des Spitzenwertgleichrichters (7, 4) zurückgeführt ist und daß die dritte Diode (10) so gepolt ist, daß die miteinander verbundenen Elektroden der Leuchtdiode (7) und der dritten Diode (10) gleiche Polarität aufweisen.

4. Geregelter Verstärker nach Anspruch 3, dadurch gekennzeichnet, daß der Leuchtdiode (7) mindestens eine vierte Diode (11) gleicher Polaritätsrichtung vorgeschaltet ist.

5. Geregelter Verstärker nach Anspruch 2, dadurch gekennzeichnet, daß als Spitzenwertgleichrichter (7, 4) eine Zener-Diode (7) Verwendung findet, der ein erster Kondensator (4) nachgeschaltet ist, daß nach der Zener-Diode (7) eine zweite Diode (12) in Sperrichtung geschaltet ist und am anderen Anschluß der zweiten Diode (12) ein RC-Glied (5, 8) angeordnet ist, daß dieser Anschluß der zweiten Diode (12) außerdem über eine dritte Diode (10) auf den Eingang des Spitzenwertgleichrichters (7, 4) zurückgeführt ist und daß die dritte Diode (10) so gepolt ist, daß die miteinander verbundenen Elektroden der Zener-Diode (7) und der dritten Diode (10) entgegengesetzte Polarität aufweisen.

6. Geregelter Verstärker nach Anspruch 5, dadurch gekennzeichnet, daß der Zener-Diode (7) eine vierte Diode (11) entgegengesetzter Polaritätsrichtung vorgeschaltet ist.

7. Geregelter Verstärker nach Anspruch 2, 3, 4, 5 oder 6, dadurch gekennzeichnet, daß zwischen dem ersten Verstärkerelement (13) und dem Spitzenwertgleichrichter (7, 4) ein zweites Verstärkerelement (2) angeordnet ist.

8. Geregelter Verstärker nach Anspruch 3, 4, 5, 6 oder 7, dadurch gekennzeichnet, daß dem Spitzenwertgleichrichter (7, 4) und der dritten Diode (10) Widerstände (6, 9) vorschaltbar sind.

9. Geregelter Verstärker nach Anspruch 7 oder 8, dadurch gekennzeichnet, daß die Arbeitspunkte des ersten und des zweiten Verstärkerelementes (13) und (2) über einen Spannungsteiler (15, 16, 17) eingestellt sind.

10. Geregelter Verstärker nach einem der Ansprüche 3 bis 9, dadurch gekennzeichnet, daß dem ersten Kondensator (4) ein Widerstand (27) parallelgeschaltet ist.
